# EUROPEAN PATENT SPECIFICATION

(11) **EP 1 913 696 B1**
(45) Date of publication and mention of the grant of the patent: **02.11.2011**
(21) Application number: 06780203.3
(22) Date of filing: 25.07.2006
(51) Int. Cl.: H03L 7/081

(54) **DELAY-LOCKED LOOP**
VERZÖGERUNGSREGELSCHLEIFE
BOUCLE A RETARD DE PHASE

(30) Priority: 03.08.2005 EP 05107151
(43) Date of publication of application: 23.04.2008
(73) Proprietor: Philips Intellectual Property & Standards GmbH, 20099 Hamburg (DE); Koninklijke Philips Electronics N.V., 5621 BA Eindhoven (NL)
(72) Inventor: PETKOV, Pavel, Philips IP &Standards GmbH, 52066 Aachen (DE); CONDER, Jim, Philips IP &Standards GmbH, 52066 Aachen (DE); GERFERS, Friedel, Philips IP &Standards GmbH, 52066 Aachen (DE)
(74) Representative: Schouten, Marcus Maria
(86) International application number: PCT/IB2006/052550
(87) International publication number: WO 2007/015191

(56) References cited:
- US-A1- 2004 070 431
- JUNG Y-J ET AL: "A DUAL-LOOP DELAY-LOCKED LOOP USING MULTIPLE VOLTAGE-CONTROLLED DELAY LINES" IEEE JOURNAL OF SOLID-STATE CIRCUITS, IEEE SERVICE CENTER, PISCATAWAY, NJ, US, vol. 36, no. 5, May 2001 (2001-05), pages 784-791, XP001222892 ISSN: 0018-9200
- PETKOV P ET AL: "An Infinite-Skew Tolerant Delay Locked Loop" CIRCUITS AND SYSTEMS, 2006. ISCAS 2006. PROCEEDINGS. 2006 IEEE INTERNATIONAL SYMPOSIUM ON KOS, GREECE 21-24 MAY 2006, PISCATAWAY, NJ, USA,IEEE, 21 May 2006 (2006-05-21), pages 4010-4013, XP010939574 ISBN: 0-7803-9389-9

## Description

The invention relates to a delay locked loop.

Delay locked loops are known from the general state of the art.

In modem high speed communications it is often necessary to align a clock to an incoming signal. This may be done by delaying the clock using a delay-locked-loop (DLL) locked to transitions in the data stream.

Such delay-locked-loops have a limited operational range (minimum and maximum delay and operating frequency) which limits the amount of clock-to-data skew that can be compensated. This in turn places tight requirements upon the data being received (often not possible in high data rate applications). To overcome this, several methods for "infinite range" delay have been proposed. These generally involve using two or more separate delay-locked-loops, each with its own control, start-up, range and stability requirements.

The simple analogue delay-locked-loop which is known from the prior art has a minimum delay determined by its physical (process technology) parameters and a maximum delay determined by the frequency of the signal being passed.

For long delays at high frequency, very long delay chains are required. This means high sensitivity of the delay line (delay per unit control signal) and this introduces jitter, which in turn restricts the maximum useful delay. A typical delay-locked-loop has a useful compensation range limited to about 2 clock periods. The initialisation of a prior art delay-locked-loops is not simple. To operate correctly the delay-locked-loop must be initialised with a known delay to ensure proper locking and sufficient range in both corrections. This requires extra circuitry.

The prior art infinite range analogue delay-locked-loop is a combination of several simple analog delay-locked-loops. Each has its own range limits and start up circuitry. The combination must be also be controlled, meaning higher order control loops, and therefore more complex stability issues.

On the other hand the prior art digital or semi-digital delay-locked-loop has multiple taps from which the delay may be selected in steps. Since the step size is generally too coarse, the required phase may be generated by interpolation. This interpolation flattens the clock edges and therefore introduces jitter. This method also has complex control circuitry. The taps required on the delay-locked-loop delay line further limit its maximum frequency of operation.

Yeon-Jae Jung Seung-Wook Lee Daeyun Shim Wonchan Kim Changhyun Kim Soo-In Cho; A dual-loop delay-locked loop using multiple voltage-controlled delay lines, appeared in Solid-State Circuits, IEEE Journal of Volume: 36 , Issue: 5, 2001 , Page(s): 784 -791, describes a dual-loop delay-locked loop (DLL) which overcomes the problem of a limited delay range by using multiple voltage-controlled delay lines (VCDLs). A reference loop generates quadrature clocks, which arc then delayed with controllable amounts by four VCDLs and multiplexed to generate the output clock in a main loop. This architecture enables the DLL to emulate the infinite-length VCDL with multiple finite-length VCDLs. The DLL incorporates a replica biasing circuit for low-jitter characteristics and a duty cycle corrector immune to prevalent process mismatches. A test chip has been fabricated using a 0.25-µm CMOS process. At 400 MHz, the peak-to-peak jitter with a quiet 2.5-V supply is 54 ps, and the supply-noise sensitivity is 0.32 ps/mV

A problem of the known delay-locked loops is that they are not applicable over a very wide frequency range with high frequency while retaining good stability. Furthermore the known delay-locked-loops are not suitable for accurate receiver clock generation in systems in which the data rate is not exactly equal to the receiver reference clock rate.

It is an object of the invention to provide an improved delay locked loop which eliminates the above-mentioned disadvantages.

To this end, according to the invention, the delay-locked-loop comprises a first delay line comprising an input for receiving a clock and a first output for providing a first delayed clock, and a second delay line comprising another input for receiving the clock and a second output for providing a second delayed clock, a clock selector for selecting one of the first delayed clock and second delayed clock a phase detector with an input for receiving data and for comparing the phase of the data to that of one of the clock selected by the phase detector, a control block which produces a control signal for controlling the two delay lines such that they react in opposite directions to a signal from the phase detector, the delay-locked-loop being characterized in that a common control signal is used to control the two delay lines which react in opposite directions to a change in the control signal.

The invention is based on the insight that a delay-locked-loop can use two parallel delay lines which react in opposite directions to a change in a control signal. According to the invention the delay-locked-loop is applicable over a very wide frequency range (typically higher than a prior art delay-locked-loop) while retaining good stability. The delay-locked-loop in accordance with the invention is also physically small and shows good noise and jitter immunity. The delay-locked-loop according to the invention may continuously increase or decrease the delay inserted into a clock path. This is equivalent to decreasing or increasing the frequency slightly. Therefore the delay locked-loop according to the invention is suitable for accurate receiver clock receiver clock generation in plesio-synchronous communication systems in which the data rate is not exactly equal to the receiver reference clock rate. Such systems have traditionally used power- and area-expensive over-sampling techniques in the receiver. With the invention not only is power area considerably reduced, but also the sampling accuracy is improved.

The delay locked loop is further characterized in that the control block interprets an output of the phase detector depending upon a currently selected delay line and compares the phase of the clocks out of the two delay lines.

In a further embodiment of the invention the control block determines a required delay line and indicates this to the clock selector, when the delay lines are aligned.

The delay-locked-loop is further characterized in that if the control signal Vc increases, the delay through positive delay line increases and the delay through negative delay line decreases.

According to claim 5 the phase detector produces a up signal which causes an increase in control signal Vc when the first delay line is selected and a decrease when the second delay line is selected.

The delay-locked-loop is further characterized in that the phase detector produces a down signal which causes an decrease in control signal Vc when the first delay line is selected and an increase when the second delay line is selected.

A feature of the invention is that the delay-locked-loop consists of a clock multiplexer which selects an output clock signal from one of two clock signal derived from the negative delay line and the positive delay line respectively.

A feature of the invention is that the delay line selector detects that the boundary of an operating area has been reached and selects the delay line so that the control signal VC is driven back into the operating area, when the clock signals derived from the negative delay line and the positive delay line are in phase.

According to the invention the delay line selector uses the current up and down signals from the data phase detector to decide which of the two clock signals becomes an active output clock.

Furthermore the delay-locked-loop is characterized in that the delay lines are arranged as a pair with opposite delay characteristics.

For this embodiment the length of the up and down signals from the phase detector are matched to a rate of the input clock of the positive delay line and the negative delay line.

The invention will be described in more detail with reference to the accompanying drawings, in which
- Fig. 1: is a block diagram of a delay-locked-loop according to the invention
- Fig. 2: is a another embodiment of a block diagram of a delay-locked-loop according to the invention
- Fig. 3: is a delay characteristic in accordance with the invention
- Fig. 4: illustrates a diagram of a delay inserted in delay lines in accordance with the invention
- Fig. 5: shows a diagram of a control signal for constantly changing delay
- Fig. 6: shows a circuitry of a delay line according to the invention
- Fig. 7: shows a circuit of delay lines according to Fig. 6 arranged as a pair of opposite characteristic in accordance to the invention
- Fig. 8: shows a circuit of delay line selector according to the invention
- Fig. 9: shows a diagram of signals of a delay line selector according to the invention
- Fig. 10: shows a clock alignment detection circuit according to the invention
- Fig. 11: shows a circuit of a delay line comparator according to the invention
- Fig. 12: illustrates a delay characteristic showing undesired operating areas in accordance of the invention
- Fig. 13: shows a block diagram with initialisation according of the invention

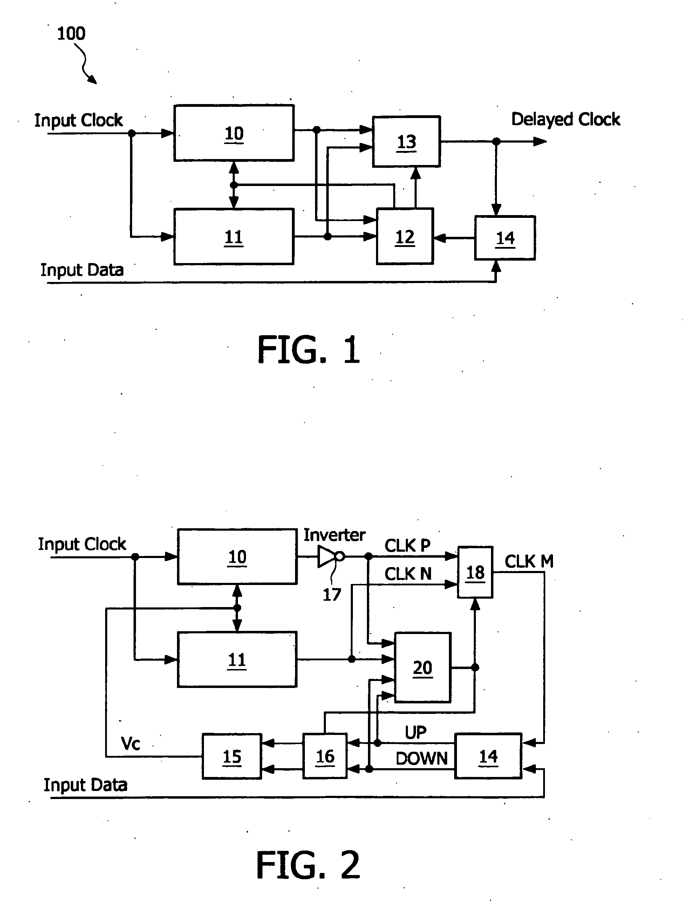

Fig. 1 shows a block diagram of a delay-locked-loop 100 according to one embodiment of the invention. The delay-locked-loop 100 comprises at least two delay elements, of which a first delay element has a positive delay line 10 and an input for receiving a clock, and of which a second delay element has a negative delay line 11 and an input for receiving a clock. Furthermore the delay-locked-loop comprises a clock selector 13 for selecting the clock from one of the two delay lines, and a phase detector 14 as well as a control block 12 which produce one or more signals for controlling the two delay lines 10,11. The phase detector 14 has an input for receiving data and for comparing the phase of the data to that of the selected clock, returning "phase up" and "phase down" pulses as appropriate. The control block also interprets the output of the phase detector 14 depending upon the currently selected delay line, and adjusts the control signal(s) to correct the phase accordingly. Thus whether a "phase up" from the phase detector 14 results in an increase or a decrease of the control signal(s) depends upon the selected delay line. The control block 12 also compares the phase of the clocks out of two delay lines 10,11. When they are aligned, the control block 12 determines the required delay line and indicates this to the clock selector 13. The delay line 10,11 is chosen such that the control signal(s) required to produce the needed delay always stay within a desired range, of which the limits are the points at which the delays through the two delay lines 10,11 are such that the clock may be selected from either delay line. Because any required change of phase will always result in control signals that are within this range, the delay-locked-loop 100 according the invention can track an infinite change of phase in the input data. Provided that the rate of change of phase is within the bandwidth of the delay-locked-loop 100, the delay-locked-loop 100 will track the data without slipping cycles. Therefore, the invention may be used to produce a clock locked to a data stream that has a frequency slightly differing from that of the received clock.

For a detailed description and a better understanding of the invention the novel delay-locked-loop will be explained in conjunction with the fig. **2** to **13****.** This refers to an embodiment of the invention that uses a common control signal to control both delay lines.

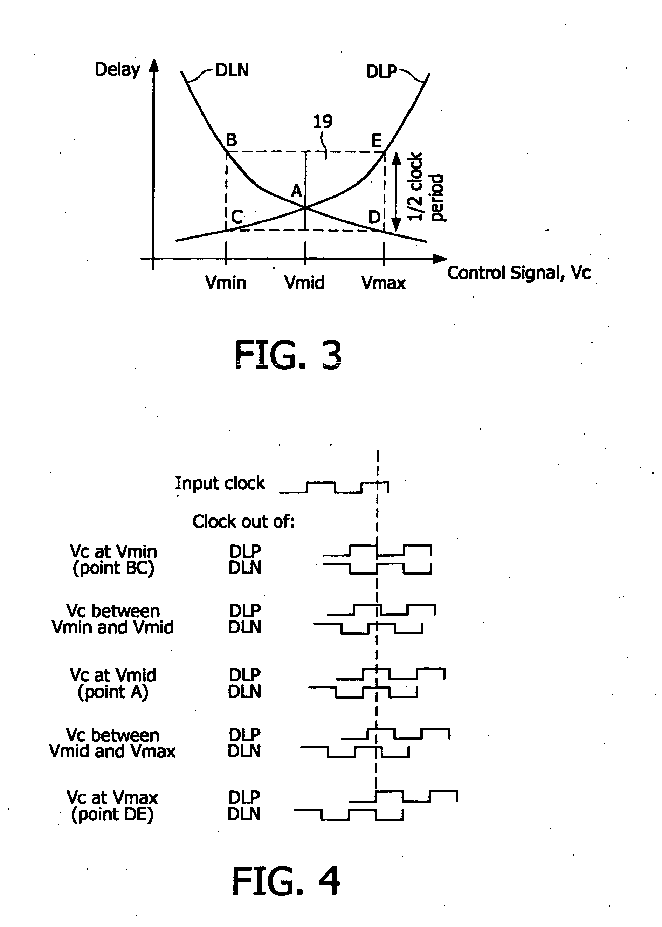

**DLP** (positive delay line) 10 and **DLN** (negative delay line) 11 in fig. 2 and 3 are two delay lines. As mentioned above the only necessary difference between them is that they react in opposite directions to a change in the control signal. If control signal **VC** increases, the delay through delay line **DLP 10** increases and the delay through delay line **DLN 11** decreases. Fig. 3 shows the resulting delay characteristic of the two delay lines 10,11. The inverter on the output of **DLP 10** in fig: 2 adds 180 degrees phase shift so that the delay-locked-loop 100 operates around its midpoint A in fig. 3. With differential clock signals, the inversion causes zero delay. With single ended clocks a small delay is introduced which shifts the operating point slightly away from midpoint A in fig. 3. This does not affect the operating principle. This inverter optimises the position of the operating area. It is not, however, inherently needed by the invention.

As shown in fig. 4. the clocks *clk_n* and *clk_p* are in phase when control signal **Vc = Vmin** and the clocks ***clk_n*** and ***clk_p*** 180 degrees out of phase when the control signal **Vc=Vmid. As Vc** moves from **Vmin** to **Vmax** in fig. 3 ***clk_p*** is delayed by half a clock period and ***clk-n*** is advanced by half a period. Thus the relative change is one period and ***clk_n*** and ***clk_p*** are in phase again. Whenever ***clk_n*** and ***elk_p*** are in phase they are indistinguishable so either of them may be selected as the source of the output clock ***clk_m.*** The clock multiplexer 18 in fig. 2 is controlled by the delay line selector 20 and selects the output clock ***clk_m*** from one of the two clocks ***clk_m*** and ***clk_p*** derived from the delay lines **DLP** 10 and **DLN** 11 respectively. The phase detector 14 in fig. 2 compares the phase ***of clk_m*** with that of the incoming data. An Alexander type phase detector 14 is typically suitable. Other types are possible. Cross-Mux 16 in fig. 2 cross-multiplexes the up and down signals from the data phase detector 14 in fig. 2 according to the currently selected delay line. Thus an up signal from the phase detector 14 in fig. 2 causes an increase in control signal **VC** when one delay line 10,11 is selected and a decrease when the other is selected, and vice versa for a down signal. The output may be forced by the delay line selector 20 in fig. 2 when the selected clock changes. The loop filter 15 in fig. 2 integrates the output of the Cross-Mux 16 in fig. 2 to produce the control signal **VC** for the delay lines 10,11. Typically this may be a charge pump and loop capacitor circuit.

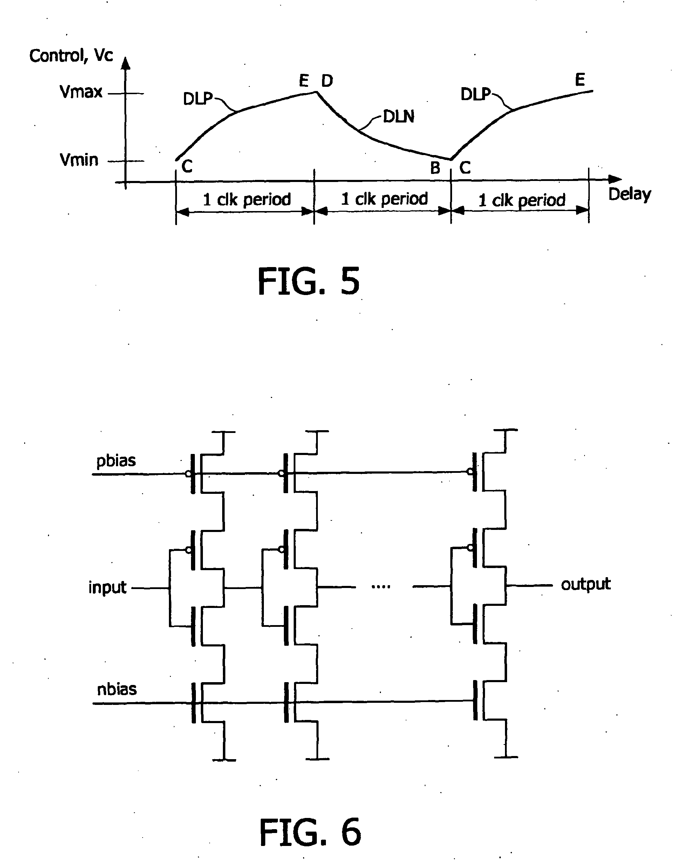

The delay line selector 20 in fig. 2 tracks the delay line output. When the ***clk_n*** and ***clk_p*** are in phase, the delay line selector 20 in fig. 2 detects that the boundary of the operating area 19, i. e. the box B-C-D-E in Fig. 3, has been reached and selects the delay line so that **VC** is driven back into the operating area 19, i.e. towards **Vmid** in fig. 3. The delay line selector 20 uses the current up and down signals from the data phase detector 14 in fig. 2 to decide which of the two clocks ***clk_n*** and ***clk_p*** becomes the active sampling clock ***clk_m.*** Should the data phase detector 14 indicate ***clk_m*** is too early, then that clock is selected for which the corresponding delay line 10,11 increases its delay when the control signal **VC** is driven towards its centre position, **Vmid**. Should the data phase detector 14 indicate that ***clk_m*** is too late, then that clock is selected for which the corresponding delay line decreases its delay when **VC** is driven towards **Vmid**. As an example assume that the data is arriving at a slightly lower rate than the clock. The phase detector 14 in fig.2 will constantly want to increase the delay in the delay line. Referring to fig. 3 and 5. the control signal will change as follows: **C → E** (switch to **DLN** 11) **D → B** (switch to **DLP** 10) **C → E**. Between points **C → E** the loop behaves as a prior-art DLL using delay line **DLP** 10, and between points **D → B** the loop behaves as a prior-art DLL using delay line **DLN** 11. At point E the delay line selector 20 in fig. 2 decides that delay line **DLN** 11 will bring the control signal back towards its centre point **Vmin** in fig. 3 since the phase detector 14 in fig. 2 indicates that more delay is required, so the system needs to increase delay while reducing the control signal level.

Two pieces of information are required - when the operating area 19 in fig. 3 is violated, and which delay line 10, 11 has the greater delay. As shown in fig. 3 the allowed (desired) limits of the control signal are **Vmin** and **Vmax,** which by definition are the points at which the delays through the two delay lines 10,11 are such that the clock may be selected from either delay line. At this point the delay line selector 20 in fig. 2 chooses the delay line which, given the current phase of the data, requires the control signal to change towards the centre of its allowed range (**towards Vmid** in fig. 2).

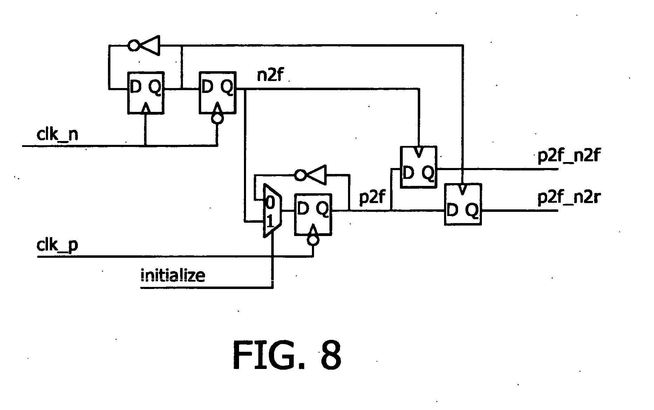

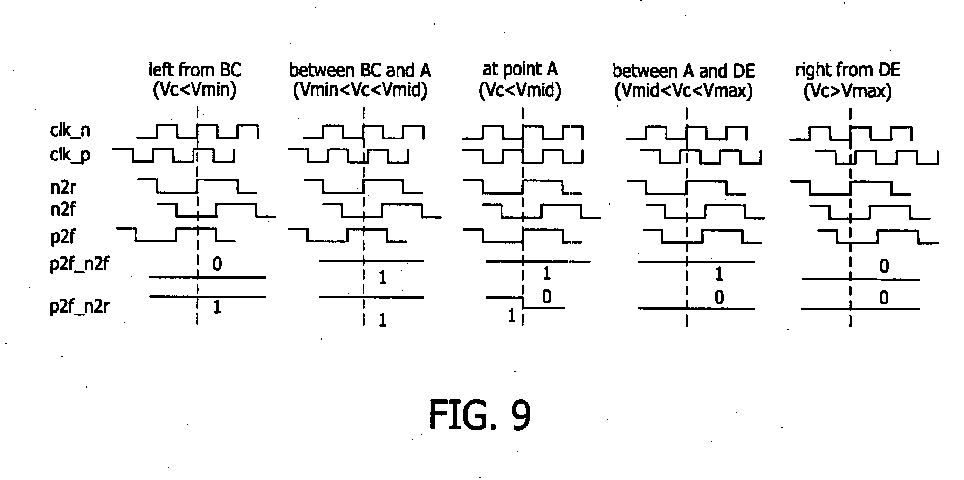

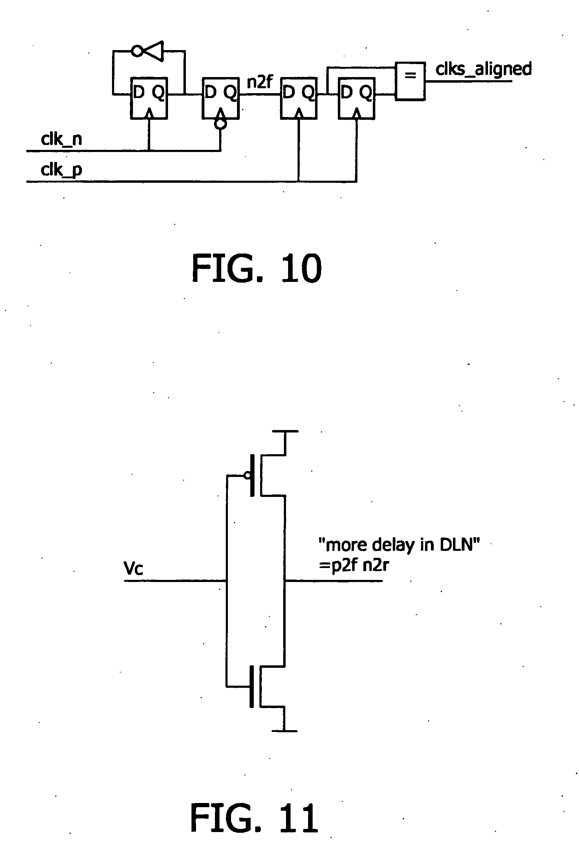

The delay line selector 20 in fig. 2 consists of a phase detector to indicate when ***clk_n*** and ***clk_p*** are in phase plus logic to determine whether the operating point is at **BC (VC =Vmin)** or **DE (VC=Vmax)** in fig. 3. A possible circuit of the operation is shown in fig. 8. At initialisation the system is brought to point **A** and the phase of the divided clocks are forced. Following this ***clk_n*** and ***clk_p*** move relative to each other, thus affecting the signals ***p2_n2f*** and ***p2-n2r*** as indicated in fig. 9. Signal ***p2f_n2r*** therefore indicates that the system has crossed its operating boundaries and that the control signal **VC** needs to be returned towards **Vmid**. Signal ***p2f_n2r*** indicates which delay line currently introduces more delay, and which direction **VC** must be changed. Because the clocks generating the ***p2f_n2f** and **p2f_n2r*** signals have half the input clock rate, recognition of the crossing of the operating area boundary may be delayed one clock, increasing clock jitter at the switching points. To avoid this an extra clock alignment detection circuit may be used as shown in fig. 10. If the system is within the operating area 19 (signal ***p2f_n2f* is** high) in fig. 3 and the clocks are not aligned (signal ***clks_aligned*** low, the delay line selector 20 in fig. 2 takes no action-the currently selected delay line continues to be used. If however, ***p2f_n2f,*** is low or ***clks_aligned*** is high, then the delay line selector 20 selects the clock source depending upon ***p2f_n2r*** and the output of the phase detector as below:

| | ***p2f_n2r = 0*** | ***p2f_n2r = 1*** |
|---|---|---|
| phase detector 14 indicates more delay required: | ***clk_n*** | ***clk_p*** |
| Phase detector 14 indicates less delay required | ***clk_p*** | ***clk_n*** |

The control signal **VC** is changed as determined by ***p2f_n2r,*** overriding the output of the cross-multiplexer 16 in fig.2.

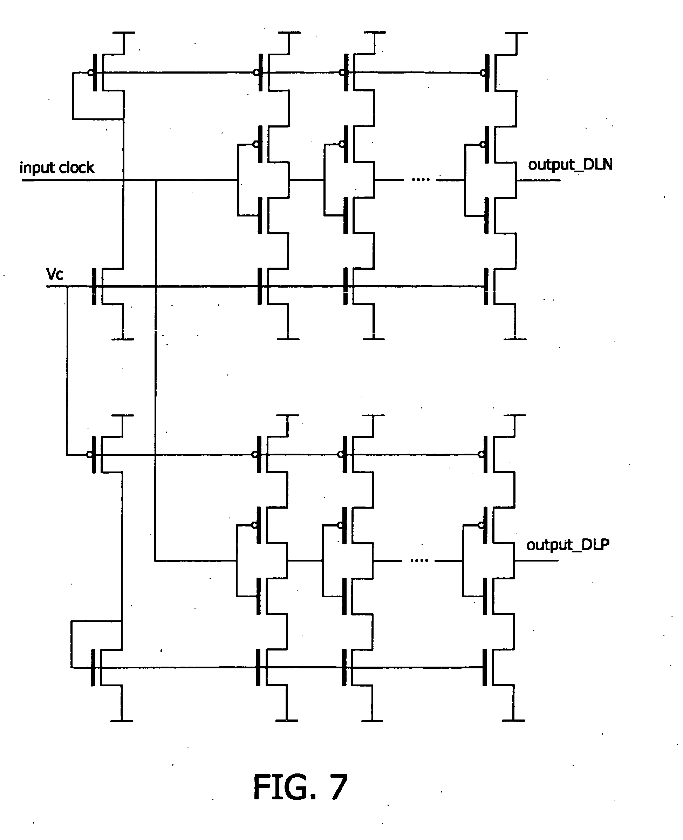

For the embodiment shown in fig. 7 which shows a circuit of delay lines (starved inverter delay lines as shown in fig. 6) arranged as a pair of opposite characteristics the signal p2f_n2r (which indicates which delay line currently introduces more delay) may be generated directly from the delay lines as shown in fig 11, since the delay is determined by the current in the delay line which in turn is set by control signal Vc. Because the difference in the delays is quite large at the switching point, errors due to mismatch are negligible. PMOS and NMOS match those used in delay lines shown in fig. 8.

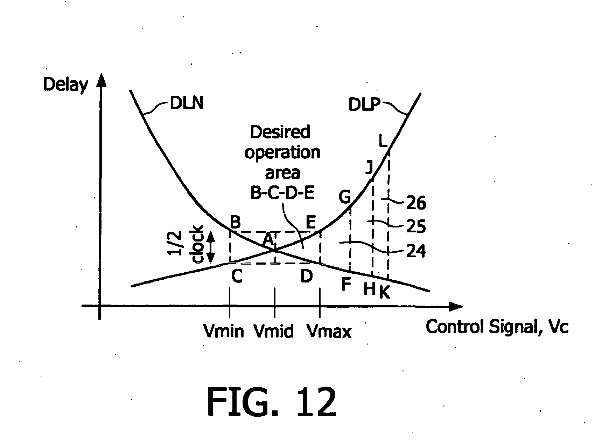

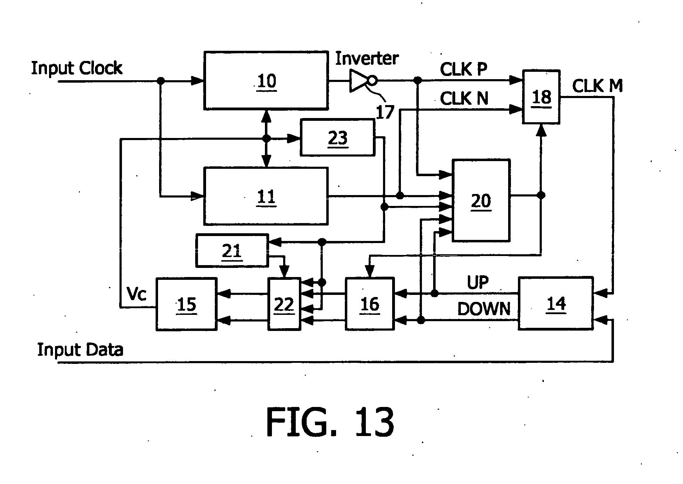

At initialisation the system must be brought to within the area B-C-D-E in fig. 3 and 12 for optimum performance. The areas 24 (A-F-G), 25(D-E-H-J), 26 (F-G-K-L) in fin. 12 are possible, but unwanted operating areas. In a preferred embodiment forced delays in each delay line are identical. The initialisation is simple-simply force the two delay paths to have equal delay. This can only occur at point A in fig. 3. In fact the system can start at any point within the working range defined by the box BCDE in fig. 3, so inaccuracies due to mismatch are unimportant for initialisation. Assuming the delay line structure described in fig. 7, and using the delay line comparator in fig. 11, the input to the loop filter 15 in fig. 13 is fed from the signal "more delay in negative delay lines", so that the loop works to force equal delays in the two delay lines 10,11. The system therefore moves towards operating point A in fig. 12. An initializer 21 in fig. 13 controls the source of the input to the loop filter 15 in fig. 13 until the loop settles at point A in fig. 12. At this point the output of the delay line comparator 23 in fig. 13 will be near the midpoint of the supply rails. The resulting complete system is shown in fig. 13.

### REFERENCE NUMERALS

- 100: delay-locked-loop
- 10: negative delay line
- 11: positive delay line
- 12: control block
- 13: clock selector
- 14: phase detector
- 15: loop filter
- 16: cross mux
- 17: inverter
- 18: mux
- 19: operating area
- 20: delay line selector
- 21: initializer
- 22: init mux
- 23: delay line comparator
- 24: area
- 25: area
- 26: area

## Claims

1. A delay- locked-loop (100) comprising
- a first delay line (10) comprising an input for receiving a clock and a first output for providing a first delayed clock, and a second delay line (11) comprising another input for receiving the clock and a second output for providing a second delayed clock;
- a clock selector (13) for selecting one of the first delayed clock and second delayed clock; a phase detector (14) with an input for receiving data and for comparing the phase of the data to that of one of the clock selected by the clock selector (13); **characterized in that** said delay-locked loop comprises
- a control block (12) for receiving an output signal from the phase detector and producing a common control signals for controlling the two delay lines (10, 11) such that they react in opposite directions to a change in the common control signal.

2. A delay-locked-loop as claimed in claim 1, **characterized in that** the control block (12) interprets an output of the phase detector (14) depending upon a currently selected delay line.

3. A delay-locked-loop as claimed in claims 1 to 2, **characterized in that** the control block (12) determines a required delay line (10, 11) and indicates this to the clock selector (13).

4. A delay-locked-loop as claimed in any of the previous claims, **characterized in that** if the common control signal increases, the delay through the first delay line (10) increases and the delay through the second delay line (11) decreases.

5. A delay-locked-loop as claimed in any of the previous claims, **characterized in that** the phase detector (14) produces a up signal which causes an increase in the common control signal when the first delay line is selected and a decrease when the second delay line is selected

6. A delay-locked-loop as claimed in any of the previous claims, wherein the phase detector (14) produces a down signal which causes a decrease in the common control signal the first delay line is selected and an increase when the second delay line is selected.

7. A delay-locked-loop as claimed in claim 1 to 6 **characterized in that** the delay-locked-loop (100) comprises a clock multiplexer (18) which selects an output crock signal from one of two clock signals derived from the second delay line (11) and the first delay line (10) respectively.

8. A delay-locked-loop as claimed in claims 1 to 7 **characterized in that** the delay-locked-loop (100) comprises a delay line selector (20) which tracks the delay line outputs.

9. A delay-locked-loop as claimed in claim 8 **characterized in that** the delay line selector (20) detects that the boundary of an operating area (19) has been reached and selects the delay line so that the common control signal is driven back into the operating area (19), when the clock signals derived from the second delay line (11) and the first delay line (10) are in phase.

10. A delay-locked-loop as claimed in claims 8 or 9 **characterized in that** the delay line selector (20) uses the current up and down signals from the phase detector (14) to decide, which of the two clock signals becomes an active output clock.

11. A delay-locked-loop as claimed in claims 1 to 10 **characterized in that** the delay lines (10, 11) are arranged as a pair with opposite characteristics.

12. A delay-locked-loop as claimed in claims 5 and 6 **characterized in that** the length of the up and down signals from the phase detector (14) are matched to a rate of the input clock of the first delay line (10) and the second delay line (11).

## Patentansprüche

1. Verzögerungsregelschleife (100) aufweisend
eine erste Verzögerungslinie (10), welche eine Eingabe zum Empfangen eines Taktes und eine erste Ausgabe zum Bereitstellen eines ersten verzögerten Taktes aufweist, und eine zweite Verzögerungslinie (11), welche eine andere Eingabe zum Empfangen des Taktes und eine zweite Ausgabe zum Bereitstellen eines zweiten verzögerten Taktes aufweist;
einen Takt-Selektor (13) zum Auswählen des ersten verzögerten Taktes oder des zweiten verzögerten Taktes;
einen Phasendetektor (14) mit einer Eingabe zum Empfangen von Daten und zum Vergleichen der Phase der Daten mit der des Taktes, welcher mittels des Takt-Selektors (13) ausgewählt ist;
**dadurch gekennzeichnet, dass** die Verzögerungsregelschleife
einen Steuerblock (12) aufweist zum Empfangen eines Ausgabesignals von dem Phasendetektor und Erzeugen eines gemeinsamen Steuersignals zum Steuern der zwei Verzögerungslinien (10, 11) derart, dass sie in entgegengesetzten Richtungen auf eine Änderung in dem gemeinsamen Steuersignal reagieren.

2. Verzögerungsregelschleife gemäß Anspruch 1, **dadurch gekennzeichnet, dass** der Steuerblock (12) eine Ausgabe des Phasendetektors (14) abhängig von einer momentanen ausgewählten Verzögerungslinie interpretiert.

3. Verzögerungsregelschleife gemäß Anspruch 1 oder 2, **dadurch gekennzeichnet, dass** der Steuerblock (12) eine erforderliche Verzögerungslinie (10, 11) bestimmt und dies dem Takt-Selektor (13) anzeigt.

4. Verzögerungsregelschleife gemäß einem der vorangehenden Ansprüche, **dadurch gekennzeichnet, dass**, wenn das gemeinsame Steuersignal ansteigt, die Verzögerung durch die erste Verzögerungslinie (10) ansteigt und die Verzögerung durch die zweite Verzögerungslinie (11) abnimmt.

5. Verzögerungsregelschleife gemäß einem der vorangehenden Ansprüche, **dadurch gekennzeichnet, dass** der Phasendetektor (14) ein Auf-Signal erzeugt, welches in dem gemeinsamen Steuersignal einen Anstieg bewirkt, wenn die erste Verzögerungslinie ausgewählt ist, und eine Abnahme bewirkt, wenn die zweite Verzögerungslinie ausgewählt ist.

6. Verzögerungsregelschleife gemäß einem der vorangehenden Ansprüche, wobei der Phasendetektor (14) ein Nieder-Signal erzeugt, welches in dem gemeinsamen Steuersignal eine Abnahme bewirkt, wenn die erste Verzögerungslinie ausgewählt ist, und einen Anstieg bewirkt, wenn die zweite Verzögerungslinie ausgewählt ist.

7. Verzögerungsregelschleife gemäß Ansprüchen 1 bis 6, **dadurch gekennzeichnet, dass** die Verzögerungsregelschleife (100) einen Taktmultiplexer (18) aufweist, welcher ein Ausgabetaktsignal von einem von zwei Taktsignalen auswählt, welche von der zweiten Verzögerungslinie (11) bzw. von der ersten Verzögerungslinie (10) abgeleitet sind.

8. Verzögerungsregelschleife gemäß Ansprüchen 1 bis 7, **dadurch gekennzeichnet, dass** die Verzögerungsregelschleife (100) einen Verzögerungslinie-Selektor (20) aufweist, welcher die Verzögerungslinie-Ausgaben verfolgt.

9. Verzögerungsregelschleife gemäß Anspruch 8, **dadurch gekennzeichnet, dass** der Verzögerungslinie-Selektor (20) detektiert, dass die Grenze eines Betriebsbereichs (19) erreicht worden ist, und die Verzögerungslinie so auswählt, dass das gemeinsame Steuersignal zurück in den Betriebsbereich (19) getrieben wird, wenn die Taktsignale, welche von der zweiten Verzögerungslinie (11) und der ersten Verzögerungslinie (10) abgeleitet sind, in Phase sind.

10. Verzögerungsregelschleife gemäß Ansprüchen 8 oder 9, **dadurch gekennzeichnet, dass** der Verzögerungslinie-Selektor (20) die momentanen Auf- und Nieder-Signale von dem Phasendetektor (14) benutzt, um zu entscheiden, welches der zwei Taktsignale ein aktiver Ausgabetakt wird.

11. Verzögerungsregelschleife gemäß Ansprüchen 1 bis 10, **dadurch gekennzeichnet, dass** die Verzögerungslinien (10, 11) als ein Paar mit entgegengesetzten Charakteristiken eingerichtet sind.

12. Verzögerungsregelschleife gemäß Ansprüchen 5 und 6, **dadurch gekennzeichnet, dass** die Länge der Auf- und Nieder-Signale von dem Phasendetektor (14) an eine Rate des Eingabetakts der ersten Verzögerungslinie (10) und der zweiten Verzögerungslinie (11) angepasst sind.

## Revendications

1. Boucle à retard de phase (100) comprenant :
une première ligne à retard (10) comprenant une entrée pour recevoir une horloge et une première sortie pour fournir une première horloge retardée, et une deuxième ligne à retard (11) comprenant une autre entrée pour recevoir l'horloge et une deuxième sortie pour fournir une deuxième horloge retardée ;
un circuit de sélection d'horloge (13) pour sélectionner l'une parmi la première horloge retardée et la deuxième horloge retardée ;
un détecteur de phase (14) avec une entrée pour recevoir des données et pour comparer la phase des données à la phase de celle des horloges qui a été sélectionnée par le circuit de sélection d'horloge (13) ;
**caractérisée en ce que** ladite boucle à retard de phase comprend un bloc de commande (12) pour recevoir un signal de sortie provenant du détecteur de phase et fournir un signal de commande commun pour commander les deux lignes à retard (10, 11) d'une manière telle qu'elles réagissent dans des directions opposées à un changement dans le signal de commande commun.

2. Boucle à retard de phase telle que revendiquée dans la revendication 1, **caractérisée en ce que** le bloc de commande (12) interprète une sortie du détecteur de phase (14) en fonction d'une ligne à retard sélectionnée sur le moment.

3. Boucle à retard de phase telle que revendiquée dans les revendications 1 à 2, **caractérisée en ce que** le bloc de commande (12) détermine une ligne à retard requise (10, 11) et indique celle-ci au circuit de sélection d'horloge (13).

4. Boucle à retard de phase telle que revendiquée dans l'une quelconque des revendications précédentes, **caractérisée en ce que** si le signal de commande commun croît, le retard à travers la première ligne à retard (10) augmente et le retard à travers la deuxième ligne à retard (11) diminue.

5. Boucle à retard de phase telle que revendiquée dans l'une quelconque des revendications précédentes, **caractérisée en ce que** le détecteur de phase (14) produit un signal haut qui provoque une croissance dans le signal de commande commun lorsque la première ligne à retard est sélectionnée et une décroissance lorsque la deuxième ligne à retard est sélectionnée.

6. Boucle à retard de phase telle que revendiquée dans l'une quelconque des revendications précédentes, dans laquelle le détecteur de phase (14) produit un signal bas qui provoque une décroissance dans le signal de commande commun lorsque la première ligne à retard est sélectionnée et une croissance lorsque la deuxième ligne à retard est sélectionnée.

7. Boucle à retard de phase telle que revendiquée dans les revendications 1 à 6, **caractérisée en ce que** la boucle à retard de phase (100) comprend un multiplexeur d'horloge (18) qui sélectionne un signal d'horloge de sortie parmi l'un des deux signaux d'horloge dérivés de la deuxième ligne à retard (11) et de la première ligne à retard (10) respectivement.

8. Boucle à retard de phase telle que revendiquée dans les revendications 1 à 7, **caractérisée en ce que** la boucle à retard de phase (100) comprend un circuit de sélection de ligne à retard (20) qui est à la suite des sorties des lignes à retard.

9. Boucle à retard de phase telle que revendiquée dans la revendication 8, **caractérisée en ce que** le circuit de sélection de ligne à retard (20) détecte que la frontière d'une zone de fonctionnement (19) a été atteinte et sélectionne la ligne à retard d'une manière telle que le signal de commande commun est ramené à l'intérieur de la zone de fonctionnement (19) lorsque les signaux d'horloge dérivés de la deuxième ligne à retard (11) et de la première ligne à retard (10) sont en phase.

10. Boucle à retard de phase telle que revendiquée dans les revendications 8 ou 9, **caractérisée en ce que** le circuit de sélection de ligne à retard (20) utilise les signaux courants haut et bas provenant du détecteur de phase (14) pour décider de celui des deux signaux d'horloge qui devient une horloge de sortie active.

11. Boucle à retard de phase telle que revendiquée dans les revendications 1 à 10, **caractérisée en ce que** les lignes à retard (10, 11) sont organisées comme une paire ayant des caractéristiques opposées.

12. Boucle à retard de phase telle que revendiquée dans les revendications 5 à 6, **caractérisée en ce que** la longueur des signaux haut et bas provenant du détecteur de phase (14) sont accordés à une cadence de l'horloge d'entrée de la première ligne à retard (10) et de la deuxième ligne à retard (11).
